Europäisches Patentamt

European Patent Office

Office européen des brevets

(11) Veröffentlichungsnummer: **0 064 733**
**B1**

# EUROPÄISCHE PATENTSCHRIFT

(45) Veröffentlichungstag der Patentschrift:
**14.08.85**

(51) Int. Cl.⁴: **G 03 F 7/02**

(21) Anmeldenummer: **82103966.6**

(22) Anmeldetag: **07.05.82**

(54) Verfahren zur Herstellung von Reliefkopien.

(30) Priorität: **13.05.81 DE 3118884**

(43) Veröffentlichungstag der Anmeldung:
**17.11.82 Patentblatt 82/46**

(45) Bekanntmachung des Hinweises auf die Patenterteilung:
**14.08.85 Patentblatt 85/33**

(84) Benannte Vertragsstaaten:
**AT BE CH DE FR GB IT LI NL SE**

(56) Entgegenhaltungen:
**Keine**

(73) Patentinhaber: **HOECHST AKTIENGESELLSCHAFT,
Postfach 80 03 20, D-6230 Frankfurt am Main 80 (DE)**

(72) Erfinder: **Frass, Werner, Dr., Erbsenacker,
D-6200 Wiesbaden (DE)**
Erfinder: **Horn, Klaus, Dr., Lessingstrasse 53,
D-6238 Hofheim/Ts. (DE)**

## Beschreibung

Die Erfindung betrifft ein Verfahren zur Herstellung von Reliefkopien, bei dem die lichtempfindliche Schicht eines lichthärtbaren Kopiermaterials, die ein photopolymerisierbares Gemisch, eine photodimerisierbare polymere Verbindung oder eine negativ arbeitende lichtempfindliche Diazoverbindung enthält, bildmässig belichtet wird und die unbelichteten Schichtbereiche mittels eines Entwicklers ausgewaschen werden.

Derartige lichthärtbare Materialien, insbesondere die photopolymerisierbaren Materialien, sind nach der bildmässigen Belichtung zumeist noch nicht vollständig ausgehärtet. Es wurde gefunden, dass in Abhängigkeit von der Wartezeit zwischen Belichtung und Entwicklung deutliche Unterschiede in der Keillänge von kopierten Halbtonstufenkeilen auftreten. Besonders ausgeprägt sind derartige Schwankungen bei der Belichtung mit Laserlicht, z.B. von einem Argon-Ionen-Laser.

In der älteren deutschen Patentanmeldung Nr. P 30 45 149 (veröffentlicht am 1.7.82) ist bereits ein Verfahren vorgeschlagen worden, mit dem diese Nachteile vermieden werden können. Das Verfahren besteht darin, dass man das eingangs genannte lichtempfindliche Material während des Belichtens oder nach dem Belichten kurze Zeit auf erhöhte Temperatur erwärmt und dann entwickelt.

Aufgabe der Erfindung war es, ein Verfahren der eingangs angegebenen Gattung vorzuschlagen, das es erlaubt, bei der Verarbeitung der dort genannten Materialien zu stets gleichbleibenden Ergebnissen zu kommen und mit einer geringeren Belichtung auszukommen.

Die Erfindung geht aus von einem Verfahren zur Herstellung von Reliefkopien, bei dem die lichthärtbare Schicht eines Kopiermaterials, die ein photopolymerisierbares Gemisch, eine photodimerisierbare polymere Verbindung oder ein Diazoniumsalz-Polykondensationsprodukt enthält, bildmässig belichtet wird und danach die unbelichteten Schichtbereiche mittels eines Entwicklers ausgewaschen werden.

Das erfindungsgemässe Verfahren ist dadurch gekennzeichnet, dass man die Schicht nach dem Belichten kurze Zeit mit Ultraschall behandelt und dann entwickelt.

Die Ultraschallbehandlung erfolgt bevorzugt möglichst bald nach dem Belichten, d.h. innerhalb einer Zeit bis zu etwa einer Stunde danach.

Die Temperatur im Ultraschallbad sollte zwischen 4 und 50°C, bevorzugt zwischen 15 und 30°C liegen.

Die Dauer des Beschallens kann zwischen 5 Sekunden und 40 Minuten, vorzugsweise zwischen 30 Sekunden und 15 Minuten liegen.

Je geringer der Zeitabstand zwischen Belichtung und Beschallen ist, desto kürzer kann die Zeitdauer des Beschallens bemessen werden.

Das Beschallen kann in an sich bekannter Weise, z.B. durch Eintauchen der belichteten Platten in eines der handelsüblichen Ultraschallbäder, z.B. der Firma Schoeller Schall USIG-1500 (19-21 kHz, 1500 W) oder der Firma Bransonic Typ 12 (50 kHz, 60 W) erfolgen.

Die nach dem erfindungsgemässen Verfahren zu verarbeitenden lichtempfindlichen Materialien bestehen aus einer lichtempfindlichen Schicht, die sich vorzugsweise auf einem Schichtträger befindet.

Als lichtempfindliche Schichten werden photopolymerisierbare Schichten bevorzugt. Diese enthalten als wesentliche Bestandteile eine polymerisierbare Verbindung mit mindestens zwei endständigen ethylenisch ungesättigten Doppelbindungen, ein polymeres Bindemittel und einen Photoinitiator, der unter Einwirkung von aktinischer Strahlung die radikalische Polymerisation der ethylenisch ungesättigten Verbindung einzuleiten vermag. Als weitere Bestandteile kann die Schicht Stabilisatoren bzw. Inhibitoren zur Verhinderung der Dunkelpolymerisation der Monomeren, Wasserstoffdonatoren, Netzmittel, Weichmacher, sensitometrische Regler, Farbstoffe und farblose oder Farbpigmente enthalten.

Als Photoinitiatoren eignen sich eine Vielzahl von Substanzen, beispielsweise Benzoin, Benzoinether, Mehrkernchinone, z.B. 2-Ethyl-anthrachinon; Acridinderivate, z.B. 9-Phenyl-acridin, 9-p-Methoxyphenyl-acridin, 9-Acetylamino-acridin, Benz(a)acridin; Phenazinderivate, z.B. 9,10-Dimethyl-benz(a)phenazin, 9-Methyl-benz(a)phenazin, 10-Methoxy-benz-(a)phenazin; Chinoxalinderivate, z.B. 6,4',4''-Trimethoxy-2,3-diphenyl-chinoxalin, 4',4''-Dimethoxy-2,3-diphenyl-5-aza-chinoxalin; Chinazolinderivate; synergistische Mischungen verschiedener Ketone; Farbstoff/Redoxsysteme; Thiopyryliumsalze und dgl. mehr.

Die Photoinitiatoren werden im allgemeinen in einer Menge von 0,01 bis 10, bevorzugt von 0,2 bis 5 Gew.-%,bezogen auf die Bestandteile der photopolymerisierbaren Schicht, zugesetzt.

Für die Zwecke der Erfindung geeignete photopolymerisierbare Monomere sind bekannt und z.B. in den USA-Patentschriften 2 760 863 und 3 060 023 beschrieben.

Bevorzugte Beispiele sind Acryl- und Methacrylsäureester, wie Diglycerindiacrylat, Polyethylenglykoldimethacrylat, Acrylate und Methacrylate von Trimethylolethan, Trimethylolpropan und Pentaerythrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-A-2 064 079 und DE-A-2 361 041 beschrieben.

Der Mengenanteil der Schicht an Monomeren beträgt im allgemeinen etwa 10 bis 80, vorzugsweise 20 bis 60 Gew.-%.

Als Wasserstoffdonatoren werden in der Hauptsache aliphatische Polyether verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z.B. Gelatine, Celluloseether und dgl.

Mit besonderem Vorteil werden Bindemittel verwendet, die wasserunlöslich, aber in wässrig-alkalischen Lösungen löslich oder mindestens quellbar sind, da sich Schichten mit solchen Bindemitteln mit den bevorzugten wässrig-alkalischen Entwicklern entwickeln lassen. Derartige Bindemittel können z.B. die folgenden Gruppen enthalten: -COOH, -PO$_3$H$_2$, -SO$_3$H, -SO$_2$NH-, -SO$_2$CO- und dgl. Als Beispiele hierfür seien genannt: Maleinatharze, Polymerisate aus N-(p-Tolyl-sulfonyl)-carbaminsäure-($\beta$-methacryloyloxy-ethyl)ester und Mischpolymerisate dieser und ähnlicher Monomerer mit anderen Monomeren sowie Styrol-Maleinsäureanhydrid-Mischpolymerisate. Methylmethacrylat-Methacrylsäure-Mischpolymerisate und Mischpolymerisate aus Methacrylsäure, Alkylmethacrylaten und Methylmethacrylat und/oder Styrol, Acrylnitril u.a., wie sie in den DE-A-2 064 080 und 2 363 806 beschrieben sind, werden bevorzugt.

Die Menge des Bindemittels beträgt im allgemeinen 20 bis 90, vorzugsweise 40 bis 80 Gew.-% der Bestandteile der Schicht.

Es ist im allgemeinen günstig, die photopolymerisierbare Schicht während der Lichtpolymerisation dem Einfluss des Luftsauerstoffs weitgehend zu entziehen, d.h. vor allem die Nachdiffusion des Luftsauerstoffs in die Schicht zu verhindern. Dies ist besonders wichtig, wenn man — z.B. bei der Belichtung durch Projektion oder mit Laserstrahlung — ohne Vakuumkopierrahmen arbeitet. Im Fall der Anwendung des Gemisches in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z.B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen lässt. Hierfür geeignete Materialien sind z.B. Wachse, Polyvinylalkohol, Polyphosphate, Zucker usw.

Als photopolymerisierbare Substanzen kommen vor allem Zimtsäurederivate in Betracht, insbesondere Zimtsäureester von Polyhydroxyverbindungen, wie Polyvinylcinnamat. Kopiermaterialien dieser Art sind in der GB-A-695 197 beschrieben.

Kopiermaterialien auf Basis von Diazoniumsalz-Polykondensationsprodukten können ebenfalls verwendet werden.

Als Diazoniumsalz-Polykondensationsprodukte sind Kondensationsprodukte kondensationsfähiger aromatischer Diazoniumsalze, z.B. von Diphenylamin-4-diazoniumsalzen, mit Aldehyden, bevorzugt Formaldehyd, geeignet. Mit besonderem Vorteil werden Mischkondensationsprodukte verwendet, die ausser den Diazoniumsalzeinheiten noch andere, nicht lichtempfindliche Einheiten enthalten, die von kondensationsfähigen Verbindungen, insbesondere aromatischen Aminen, Phenolen, Phenoläthern, aromatischen Thioäthern, aromatischen Kohlenwasserstoffen, aromatischen Heterocyclen und organischen Säureamiden, abgeleitet sind. Diese Kondensationsprodukte sind in der US-A-3 867 147 beschrieben. Allgemein sind alle Diazoniumsalz-Polykondensationsprodukte geeignet, die in der US-A-4 186 017 beschrieben sind.

Die lichtempfindlichen Schichten dieser Kopiermaterialien können ausser dem Bindemittel, Farbstoffe, Indikatoren, Pigmente, Stabilisatoren, Netzmittel und weitere übliche Zusätze enthalten. Die Bindemittel können wasserlöslich oder wasserunlöslich sein. Mit Vorteil werden wasserunlösliche harzartige Bindemittel, insbesondere in Kombination mit den bevorzugten Mischkondensationsprodukten von Diazoniumsalzen, verwendet. Beispiele für geeignete Bindemittel sind Polyalkylacrylate, Methacrylsäure-Alkylmethacrylat-Mischpolymerisate, Polymere mit seitenständigen Sulfonylurethangruppen, Phenolharze, Harnstoffharze, Melaminharze, Epoxyharze, Polyurethane, Polyvinylester und Polyvinylacetale.

Der Mengenanteil an Diazoniumsalz-Polykondensationsprodukt liegt im allgemeinen bei 10 bis 100, bevorzugt 20 bis 95 Gew.-%, die Menge des Bindemittels beträgt 0 bis 90, vorzugsweise 5 bis 80 Gew.-% der gesamten Schicht.

Die Art des Schichtträgers richtet sich nach dem Verwendungszweck des lichtempfindlichen Materials. Zur Herstellung von Flachdruckplatten wird im allgemeinen Aluminium verwendet, das bevorzugt eine anodisch erzeugte poröse Oxidschicht trägt. Das Aluminium wird zweckmässig vor dem Anodisieren mechanisch, chemisch oder elektrolytisch aufgerauht. Die Anodisierung erfolgt in bekannter Weise, z.B. in Schwefel- und/oder Phosphorsäure, vorzugsweise unter solchen Bedingungen, dass eine Oxidschicht mit einem Schichtgewicht von etwa 0,5 bis 10 g/m$^2$ erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z.B. mit Silikaten, Polyvinylphosphonsäure, Hexafluorozirkonaten, Heteropolysäuren, Tetraalkyltitanaten und Polyacrylsäuren. Die Beschichtung des Trägermaterials erfolgt in bekannter Weise durch Aufschleudern, Sprühen, Tauchen, mittels Walzen, Schlitzdüsen, Rakeln oder durch Giesser-Antrag.

Ausser Aluminium können auch Stahl, Zink, Kupfer, verchromter Stahl oder verchromtes Kupfer, Kunststoffolien, z.B. aus Polyethylenterephthalat oder Celluloseacetat, oder Siebdruckträger, z.B. Perlongaze oder Nickelsiebe, verwendet werden.

Das erfindungsgemässe Verfahren wird bevorzugt zur Herstellung von Flachdruckformen angewendet. Es kann auch zur Herstellung von Tiefdruckformen, Hoch- und insbesondere Flexodruckformen, Siebdruckschablonen, Ätz- und Galvanoschablonen dienen.

Die Bebilderung der Kopiermaterialien erfolgt in bekanntner Weise, z.B. durch Kontaktbelichtung unter einer Transparentvorlage. Dabei werden die üblichen Lichtquellen wie Kohlenbogenlampen, Xenonlampen, mit Metallhalogeniden dotierte Quecksilberhochdrucklampen und dgl. verwendet.

Mit Vorteil kann die Bebilderung auch mit Laserlicht erfolgen, z.B. mit einem Argon-Ionen-Laser. Bei dieser Belichtungsart wird nach dem erfindungsgemässen Verfahren eine besonders hohe Steigerung der Belichtungswirkung erzielt.

Im Rahmen des vorliegenden Verfahrens ist zur Bildbelichtung allgemein aktinisches Licht geeignet, d.h. Strahlung im Bereich des nahen Ultravioletts und des kurzwelligen sichtbaren Lichts.

Die Entwicklung der belichteten und erwärmten Kopiermaterialien erfolgt in bekannter Weise durch Auswaschen der unbelichteten Schichtbereiche mit einem Entwickler. Die Zusammensetzung des Entwicklers richtet sich nach der Natur und Löslichkeit der lichtempfindlichen Schicht. Geeignete Entwickler sind organische Lösungsmittel oder Lösungsmittelgemische, Wasser, das kleine Mengen organischer Lösungsmittel oder Netzmittel enthalten kann, und insbesondere alkalische oder schwach saure wässrige Lösungen, die Puffersalze, Neutralsalze, organische Lösungsmittel, Netzmittel, Farbstoffe und andere übliche Zusätze enthalten können. Bevorzugt werden Entwickler, die frei von organischen Lösungsmitteln sind.

Durch die Erfindung wird erreicht, dass die Härtung der belichteten Schichtbereiche in solchem Masse gesteigert wird, dass die Belichtungszeit auf etwa die Hälfte des ohne Ultrabeschallung Erforderlichen herabgesetzt werden kann. Bei Laserbestrahlung können noch grössere Unterschiede erzielt werden. Als zusätzliche Wirkung der Ultraschallbehandlung tritt eine deutlich bessere Durchhärtung der belichteten Schichtbereiche ein. Ferner werden die Rasterpartien sauberer durchentwickelt, die Halbtonkeil-Abbrüche werden schärfer, und unvernetzte Schichtteile werden schneller entwickelt. Dieser Vorteil wirkt sich besonders bei der Herstellung von Druckplatten, insbesondere Flachdruckplatten, aus, bei denen von der gehärteten Bildschicht gedruckt werden soll.

Die folgenden Beispiele erläutern die Erfindung. Gewichtsteile (Gt) und Volumenteile (Vt) stehen im Verhältnis von g zu ml. Prozentangaben und Mengenverhältnisse sind, wenn nichts anderes angegeben ist, in Gewichtseinheiten zu verstehen.

*Beispiel 1*

Als Schichtträger für Druckplatten wurde elektrochemisch aufgerauhtes und anodisiertes Aluminium mit einer Oxidschicht von 3 g/m$^2$ verwendet, das mit einer 0,1%igen wässrigen Lösung von Polyvinylphosphonsäure vorbehandelt worden war. Der Träger wurde mit einer Lösung folgender Zusammensetzung überzogen:

11,7 Gt einer 34,7%igen Lösung eines Methylmethacrylat/Methylacrylsäure-Mischpolymerisats mit der Säurezahl 110 und dem mittleren Mol-Gewicht 35 000 in Methyläthylketon,

2,0 Gt des Dimethylesters der Hepta-1,6-dien-2,6-dicarbonsäure,

2,0 Gt Trimethylolethantriacrylat,

0,07 Gt 9-Phenyl-acridin,

0,07 Gt 4-Dimethylamino-4'-methyl-dibenzalaceton,

0,04 Gt eines Azofarbstoffs aus 2,4-Dinitro-6-chlor-benzodiazoniumsalz und 2-Methoxy-5-acetylamino-N-cyanethyl-N-hydroxyethylanilin,

38,0 Gt Ethylenglykolmonoethylether,

13,5 Gt Butylacetat.

Das Auftragen erfolgte durch Aufschleudern in der Weise, dass ein Trockengewicht von 2,8-3 g/m$^2$ erhalten wurde. Anschliessend wurde die Platte 2 Minuten bei 100°C im Umlufttrockenschrank getrocknet.

Die lichtempfindliche beschichtete Platte wurde mit einer 15%igen wässrigen Lösung von Polyvinylalkohol (12% Restacetylgruppen, K-Wert 4) beschichtet. Nach dem Trocknen wurde eine Deckschicht mit einem Gewicht von 4-5 g/m$^2$ erhalten.

Die erhaltene Druckplatte wurde mittels einer 5-kW-Metallhalogenidlampe im Abstand von 110 cm unter einem 13stufigen Belichtungskeil mit Dichteinkrementen von 0,15 30 Sekunden belichtet.

Die belichtete Platte wurde halbiert. Die eine Hälfte wurde sofort entwickelt, die andere Hälfte wurde durch ein handelsübliches Ultraschallgerät, (USIG 1500 der Firma Schoeller Schall, Frankfurt, 15-21 kHz, 1500 W) geschickt, dessen Wasserbad auf 25°C erwärmt war. Die Verweilzeit der Platte in dem Gerät betrug 10 Minuten.

Anschliessend wurden beide Plattenhälften mit einem Entwickler folgender Zusammensetzung entwickelt:

120 Gt Natriummetasilikat x 9 H$_2$O,

2,13 Gt Strontiumchlorid,

1,2 Gt nichtionogenes Netzmittel (Kokosfettalkohol-Polyoxyethylenether mit ca. 8 Oxyethyleneinheiten),

0,12 Gt Antischaummittel,

4000 Gt vollentsalztes Wasser.

Die Platte wurde mit 1%iger Phosphorsäure sauer gestellt und mit fetter Druckfarbe eingefärbt. Es wurden die folgenden vollvernetzten Keilstufen erhalten:

| mit Ultraschall | ohne Ultraschall |
|---|---|
| 6 | 4 |

Die Druckplatte, die vor dem Entwickeln ultrabeschallt worden war, ergab eine Druckauflage von 210 000, die nicht beschallte eine von 190 000 Drucken.

*Beispiel 2*

Auf den in Beispiel 1 angegebenen Schichtträger wurde eine Lösung folgender Zusammensetzung so aufgeschleudert, dass ein Schichtgewicht von 3 g/m$^2$ erhalten wurde:

11,7 Gt der in Beispiel 1 angegebenen Mischpolymerisatlösung,

38,0 Gt Ethylenglykolmonoethylether,

13,5 Gt Butylacetat,

3,9 Gt des Diethylesters der Hepta-1,6-dien-2,6-
-dicarbonsäure,
0,07 Gt 9-Phenyl-acridin,
0,04 Gt des in Beispiel 1 angegebenen Azofarbstoffs,
0,07 Gt 4-Dimethylamino-4'-methyl-dibenzal-
aceton.

Die Platte wurde in gleicher Weise wie in Beispiel 1 weiterverarbeitet.
Es wurde die folgende Anzahl vollvernetzter Keilstufen erhalten:

| Ultraschall (5 Minuten 38°C) | ohne Ultraschall |
|---|---|
| 7 | 5 |

Es wurde ein Druckversuch durchgeführt. Dazu wurde die mit fetter Farbe eingefärbte Offsetdruckplatte in eine handelsübliche Druckmaschine (Heidelberg Typ GTO) eingespannt. Nach 200 000 Drucken wurde der Druckversuch abgebrochen, obwohl noch keine Ausbrüche im 60er Raster festzustellen war.

Vergleichbare Ergebnisse wurden erhalten, wenn anstelle von 9-Phenylacridin das 2,2-Dimethoxy-2-
-phenylacetophenon oder 2-(4-Ethoxy-naphth-1-yl)-
-4,6-bis-trichlormethyl-s-triazin oder 2-(Acenaphth-
-5-yl)-4,6-bis-trichlormethyl-s-triazin verwendet wurde.

*Beispiel 3*

Auf den in Beispiel 1 angegebenen Schichtträger wurde eine Lösung folgender Zusammensetzung so aufgeschleudert, dass ein Schichtgewicht von 3,5 g/m² erhalten wurde:

10,0 Gt einer 21,7%igen Lösung eines Terpolymerisats aus Styrol, n-Hexylmethacrylat und Methacrylatsäure (10:60:30) mit der Säurezahl 190 in Butanon,
2,0 Gt Trimethylolethantriacrylat,
0,06 Gt 9-Phenyl-acridin und
0,03 Gt Methylviolett (C.I. 42 535) in
18,0 Gt Butanon und
7,5 Gt Butylacetat.

Die beschichtete Platte wurde anschliessend 2 Minuten bei 100°C im Umlufttrockenschrank getrocknet und mit einer Deckschicht wie in Beispiel 1 versehen. Die Platte wurde unter einem 13stufigen Belichtungskeil wie in Beispiel 1 beschrieben 4, 8, 15 und 30 Sekunden belichtet und mit einem Entwickler folgender Zusammensetzung entwickelt:

5,3 Gt Natriummetasilikat x 9 $H_2O$,
3,4 Gt tert. Natriumphosphat x 12 $H_2O$,
0,3 Gt sec. Natriumphosphat,
91,0 Gt vollentsalztes Wasser.

Parallel dazu wurde eine Platte in gleicher Weise hergestellt und belichtet, jedoch unmittelbar nach dem Belichten 15 Minuten in Wasser von 22°C mit dem in Beispiel 1 angegebenen Ultraschallgerät beschallt. Die Platten wurden mit 1%iger Phosphorsäure sauer gestellt und mit fetter Druckfarbe eingefärbt. Die Auszählung der vollvernetzten Glanzstufen ergab folgendes Bild:

| Belichtungszeit: | | S e k u n d e n | | | |
|---|---|---|---|---|---|
| MH-Lampe 5 kW | | 4 | 8 | 15 | 30 |
| entsprechende | ohne *) | 0 | 1 | 3 | 5 |
| vollvernetzte Glanzstufen | mit *) | 1 | 3 | 5 | 7 |

*) Ultraschall, 15 Minuten in Wasser von 22°C

*Beispiel 4*

Eine wie in Beispiel 3 beschrieben hergestellte Druckplatte wurde unter einem 13stufigen Halbtonstufenkeil 30 Sekunden belichtet. Es wurden 5 Keilstufen erhalten. Eine weitere entsprechende Platte wurde 15 Sekunden belichtet und anschliessend 5 Minuten ultrabeschallt. Beide Platten ergaben 5 gehärtete Keilstufen.

Die Platten wurden dann auf einer handelsüblichen Druckmaschine (Heidelberger GTO) gedruckt. Die nicht ultrabeschallte Platte zeigte nach 150 000 Drucken bereits Ablauferscheinungen, die beschallte Platte erst nach 180 000 Drucken.

*Beispiel 5*

Auf den in Beispiel 1 angegebenen Schichtträger wurde eine Lösung folgender Zusammensetzung so aufgeschleudert, dass ein Schichtgewicht von 3,5 g/m² erhalten wurde:

2,6 Gt des Diethylesters der Hepta-1,6-dien-
-2,6-dicarbonsäure,
6,5 Gt eines Styrol-Maleinsäureester-Mischpolymerisats mit einer Säurezahl von 145-160 und einem Erweichungspunkt von140-160°C,
70,0 Gt Ethylenglykolmonomethylether,
0,1 Gt 9-Phenyl-acridin,
0,035 Gt des in Beispiel 1 angegebenen Azofarbstoffs und
1,0 Gt des Umsetzungsproduktes aus 1 Mol 2,2,4-Trimethyl-hexamethylendiisocyanat und 2 Mol 2-Hydroxy-ethylmethacrylat.

Die beschichtete Platte wurde anschliessend 2 Minuten bei 100°C im Umlufttrockenschrank getrocknet und mit einer Deckschicht wie in Beispiel 1 versehen. An einem Laserite®-Gerät-150 R der Firma Ecom Corp., das mit einem Argon-Ionen-Laser ausgerüstet war, wurde die Platte mit 200 mW und 1200 L/inch = 5,3 mJ/cm² bestrahlt. Der Bildkontrast nach der Bestrahlung war gut. Anschliessend wurde die Platte mit dem Entwickler von Beispiel 1 entwickelt. Die Zahl der vollvernetzten Keilstufen eines Halbtonstufenkeils betrug bei Belichtung und unmittelbar folgender Entwicklung 3.

Wenn eine gleiche Platte in gleicher Weise verarbeitet wurde, jedoch zwischen Belichten und Entwickeln in einem Ultraschallgerät 10 Minuten in Wasser von 20°C beschallt wurde, so wurden 7 Keilstufen erhalten.

Lässt man die Platte nach der Belichtung 1 Stunde liegen, beschallt anschliessend und entwickelt dann, so werden ebenfalls 7 Keilstufen erhalten.

Andruck und Auflagedruck wurden in einer Heidelberger Offsetdruckmaschine GTO mit alkoholischem Feuchtwasserr durchgeführt und betrugen 150 000 Bogen. Bei der beschallten Platte erhöhte sich die Auflage auf 170 000 Bogen.

*Beispiel 6*

a) Auf eine elektrochemisch aufgerauhte und anodisierte Aluminiumoberfläche mit einer Oxidschicht von 3 g/m$^2$ wurde eine Lösung folgender Zusammensetzung so aufgeschleudert, dass ein Schichtgewicht von 3 g/m$^2$ erhalten wurde:

11,4 Gt der in Beispiel 1 angegebenen Mischpolymerisatlösung,
37,9 Gt Ethylenglykolmonoethylether,
13,34 Gt Butylacetat,
4,0 Gt Trimethylolethantriacrylat,
0,07 Gt 4-Methyl-benzalchinaldin,
0,08 Gt des in Beispiel 1 angegebenen Azofarbstoffs,
0,07 Gt 4-Dimethylamino-4'-methyl-dibenzalaceton,
0,56 Gt Bisundecyldisulfid.

Die beschichtete Platte wurde 2 Minuten im Trockenschrank bei 100°C getrocknet.

b) Eine weitere Platte wurde in gleicher Weise hergestellt und mit einer Deckschicht von 4-5 g/m$^2$ Polyvinylalkohol wie in Beispiel 1 versehen.

c) Eine dritte Platte wurde wie unter a), jedoch ohne Zusatz von Bisundecyldisulfid hergestellt.

d) Eine vierte Platte wurde wie unter c) hergestellt und mit einer Deckschicht gemäss b) versehen.

Proben der erhaltenen Offsetdruckplatten wurden mittels einer Metallhalogenidlampe von 5 kW 10, 20 und 40 Sekunden unter einem 13stufigen Belichtungskeil mit Dichteinkrementen von 0,15 belichtet.

Je eine Hälfte der unter a) bis d) beschriebenen Platten wurde nach der Belichtung durch das in Beispiel 1 angegebene Ultraschallgerät geschickt. Die Temperatur betrug 25°C, die Verweilzeit 50 Sekunden. Die andere Hälfte wurde jeweils nicht beschallt.

Anschliessend wurden alle Platten mit dem in Beispiel 1 beschriebenen Entwickler entwickelt.

Sie wurden dann mit 1%iger Phospshorsäure sauer gestellt und mit fetter Durckfarbe eingefärbt. Es wurde die folgende Anzahl vollvernetzter Keilstufen erhalten:

| | | | Belichtungszeit (Sekunden) | | | | | |
| | | | ohne Ultra-schall | | | mit Ultra-schall | | |
| Platte | Deck-schicht | Di-sulfid | 10 | 20 | 40 | 10 | 20 | 40 |
|---|---|---|---|---|---|---|---|---|
| a | — | + | — | 1 | 3 | — | 1,5 | 3,5 |
| b | + | + | — | 1 | 3 | 1 | 3 | 4 |
| c | — | — | — | — | 2 | — | 1 | 3 |
| d | + | — | — | 1 | 3 | 1 | 3 | 4 |

*Beispiel 7*

Um die breite Anwendung des Verfahrens zu zeigen, wurden handelsübliche photopolymerisierbare Flachdruckplatten (Lydel® la, Du Pont, und XN, 3 M Co.) 30 Sekunden unter einen Halbtonkeil belichtet und anschliessend 30 Sekunden einer Ultraschallbehandlung unterworfen. Danach wurden die Platten mit den von den Herstellern gelieferten Entwicklern und nach den angegebenen Vorschriften entwickelt. Vergleichsmuster ohne Ultraschallbehandlung wurden direkt entwickelt.

Folgende Keilstufen wurden erhalten:

| | Lydel la | | XN | |
| Belicht-tungszeit (sec) | ohne Ultra-schall | mit Ultra-schall | ohne Ultra-schall | mit Ultra-schall |
|---|---|---|---|---|
| 30 | 7 | 8 | 6 | 7 |

*Beispiel 8*

Eine Lösung von

0,6 Gt des Polykondensationsprodukts aus 1 Mol 3-Methoxy-diphenylamin-4-diazoniumsalz und 1 Mol 4,4'-Bis-methoxymethyl-diphenylether, isoliert als Mesitylensulfonat,
0,05 Gt Phosphorsäure,
0,27 Gt Hostapermblau B 2 G(C.I. 74 160),
1,87 Gt Polyvinylformal (Formvar 12/85) und
0,01 Gt Methylorange in
2,2 Gt Ethylenglykolmethyletheracetat und
95 Gt Ethylenglykolmonomethylether

wurde auf den in Beispiel 1 angegebenen Schichtträger aufgebracht und 4 Minuten bei 90°C getrocknet.

Eine Probe der erhaltenen Druckplatte wurde unter einem 13stufigen Belichtungskeil 40 Sekunden belichtet und anschliessend mit einer Lösung von

5,7 Gt MgSO$_4$ x 7 H$_2$O,
20,2 Gt n-Propanol,
1 Gt Ethylenglykolmonobutylehter und
0,7 Gt eines ethoxylierten Alkylphenols in
72,4 Gt Wasser

entwickelt. Es wurden 5 vollvernetzte Keilstufen erhalten.

Eine weitere Probe der gleichen lichtempfindlichen Druckplatte wurde wie oben angegeben belichtet, jedoch nach der Belichtung bei 40°C 10 Minuten ultraschallbehandelt. Nach dem Entwickeln wurden 6-7 Keilstufen erhalten.

*Beispiel 9*

Auf eine elektrochemisch aufgerauhte und anodisch oxydierte Aluminiumplatte wurde eine Lösung von

7 Gt Polyvinylcinnamat,
12,5 Gt eines Epoxyharzes mit dem Epoxyäquivalentgewicht 365-420 (Araldite B),
2 Gt eines hydrierte Kolophoniumharzesters (Staybelite Ester 10),
0,07 Gt 2-Benzoylmethylen-1-methyl-β-naphthothiazolin und
10 Gt Renol Carmin FBB-H(C.I. 12 485) in
90 Gt Ethylenglykolethyletheracetat

aufgebracht und 3 Minuten bei 90°C getrocknet. Ein Teil der Platte wurde unter einem 13stufigen Belichtungskeil 25 Sekunden belichtet und anschliessend mit einer Lösung von

43 Gt Ethylenglykolethyletheracetat,
21 Gt Ethylenglykolmonoethylether,
15 Gt eines Additionsprodukts von ca. 8-12 Mol Ethylenoxid an Tridecanol,
12,5 Gt Butyrolacton,
4 Gt Essigsäure,
3 Gt Phosphorsäure und
0,3 Gt Wasser

entwickelt. Es wurden 7 gehärtete Keilstufen erhalten.

Eine weitere Probe der lichtempfindlichen Druckplatte wurde wie oben angegeben belichtet, jedoch nach der Belichtung 60 Sekunden ultrabeschallt. Nach dem Entwickeln wurden 9 gehärtete Keilstufen erhalten.

**Patentansprüche**

1. Verfahren zur Herstellung von Reliefkopien, bei dem die lichthärtbare Schicht eines lichthärtbaren Kopiermaterials, die ein photopolymerisierbares Gemisch, eine photodimerisierbare polymere Verbindung oder ein Diazoniumsalz-Polykondensationsprodukt enthält, bildmässig belichtet wird und danach die unbelichteten Schichtbereiche mittels eines Entwicklers ausgewaschen werden, dadurch gekennzeichnet, dass man die Schicht nach dem Belichten kurze Zeit mit Ultraschall behandelt und dann entwickelt.

2. Verfahren nach Anspruch 1, dadurch gekennzeichnet, dass man die Schicht bei einer Temperatur im Bereich von 4-50°C ultrabeschallt.

3. Verfahren nach Anspruch 1, dadurch gekennzeichnet, dass man die Schicht 5 Sekunden bis 40 Minuten ultrabeschallt.

4. Verfahren nach Anspruch 1, dadurch gekennzeichnet, dass man ein lichthärtbares Kopiermaterial mit einer photopolymerisierbaren Schicht verwendet, die eine polymerisierbare Verbindung mit mindestens zwei endständigen ethylenisch ungesättigten Doppelbindungen, ein polymeres Bindemittel und einen Photoinitiator enthält, der bei Belichtung freie Radikale zu erzeugen vermag.

**Claims**

1. A process for the production of relief copies, in which process the light-hardenable layer of a light-hardenable copying material, which layer contains a photopolymerizable mixture, a photodimerizable polymeric compound or a diazonium salt polycondensation product, is exposed imagewise and thereafter the unexposed areas of the layer are washed out by means of a developer, characterized in that said process comprises subjecting the layer briefly to ultrasonic treatment after exposure, and then developing it.

2. The process as claimed in claim 1, wherein the layer is subjected to ultrasonic treatment at a temperature within the range of 4-50°C.

3. The process as claimed in claim 1, wherein the layer is subjected to ultrasonic treatment for 5 seconds up to 40 minutes.

4. The process as claimed in claim 1, wherein a light-hardenable copying material having a photopolymerizable layer is used, which layer contains a polymerizable compound having at least two terminal ethylenically unsaturated double bonds, a polymeric binder and a photoinitiator which, on exposure, is capable of generating free radicals.

**Revendications**

1. Procédé de production de copies en relief, dans lequel la couche photodurcissable d'un matériau de reprographie photodurcissable, qui contient un mélange photopolymérisable, un composé polymère photodimérisable ou un produit de polycondensation d'un sel de diazonium, est exposée selon une image et ensuite les régions de la couche non exposées sont éliminées par lavage au moyen d'un développateur, procédé caractérisé en ce qu'après l'exposition, on traite la couche par les ultrasons pendant une courte durée et ensuite on la développe.

2. Procédé selon la revendication 1, caractérisé en ce que la couche est traitée par les ultrasons à une température comprise entre 4 et 50°C.

3. Procédé selon la revendication 1, caractérisé en ce que la couche est traitée par les ultrasons pendant 5 secondes à 40 minutes.

4. Procédé selon la revendication 1, caractérisé en ce que l'on emploie un matériau de reprographie photodurcissable comportant une couche photopolymérisable qui contient un composée polymérisable ayant au moins deux doubles liaisons à insaturation éthylénique situées en bout de chaîne, un liant polymère et un photo-initiateur qui peut donner naissance à des radicaux libres lors de l'exposition.